# EUROPEAN PATENT APPLICATION

(11) **EP 4 343 470 A1**
(43) Date of publication of application: **27.03.2024**
(21) Application number: 23198366.9
(22) Date of filing: 19.09.2023
(51) Int. Cl.: G05B 19/408

(54) **SUBSTRATE PROCESSING APPARATUS, METHOD OF MANUFACTURING SEMICONDUCTOR DEVICE AND PROGRAM**

(30) Priority: 20.09.2022 JP 2022149293
(71) Applicant: Kokusai Electric Corp., Tokyo 1010045 (JP)
(72) Inventor: TAKEBAYASHI, Yuri, Toyama-shi, 939-2393 (JP); MORI, Shinichiro, Toyama-shi, 939-2393 (JP); KAWASAKI, Junichi, Toyama-shi, 939-2393 (JP)
(74) Representative: Verscht, Thomas Kurt Albert

(57) **Abstract**

According to the present disclosure, there is provided a technique capable of rapidly identifying a cause of an occurrence of a failure and supporting a recovery. There is provided a technique that includes: a memory storing recipes, apparatus information reported from within the substrate processing apparatus and failure information; a process vessel in which a substrate is processed based on a recipe; and a controller for: (i) storing failure data in the memory together with an occurrence time of the failure contained in the failure information when the failure occurs in the substrate processing apparatus, the failure data containing first apparatus-related information reported before the failure during a first period defined in advance and the recipe in the memory; and (ii) adding second apparatus-related information reported after the failure during a second period defined in advance to the failure data.

## Description

### [Technical Field]

The present disclosure relates to a substrate processing apparatus, a method of manufacturing a semiconductor device and a program.

### [Related Art]

In a substrate processing apparatus, it is important to reduce a time from identification of a cause of a failure of the substrate processing apparatus to resolution of the failure after the failure occurs in order to improve a productivity of the substrate processing apparatus. According to some related arts, when the failure occurs, apparatus data at that time is stored as failure information and provided to a user of the substrate processing apparatus such that the cause can be identified.

For example, according to Patent Document 1, when the failure is detected, monitor data corresponding to an analysis item is acquired, and a display screen including a region configured to display an alarm occurrence history and a region configured to display the monitor data corresponding to the analysis is displayed.

That is, according to some related arts, when the failure of the substrate processing apparatus occurs, the apparatus data at that time (that is, when the failure occurs) alone may be provided to the user to identify the failure. Therefore, since information about an occurrence the failure is insufficient, it takes time to identify (or specify) the cause of the occurrence of the failure.

### [Related Art Document]

### [Patent Document]

Patent Document 1: Japanese Patent Laid-Open No. 2021-150540

### [Disclosure]

### [Technical Problem]

According to the present disclosure, there is provided a technique (configuration) capable of rapidly identifying a cause of an occurrence of a failure and supporting a recovery.

### [Technical Solution]

According to one embodiment of the present disclosure, there is provided a technique that includes: a memory configured to store a plurality of recipes in which process conditions of a substrate are defined, apparatus information reported from within the substrate processing apparatus and failure information generated when a failure occurs in the substrate processing apparatus; a process vessel in which a processing of the substrate is capable of being executed based on a recipe designated among the plurality of recipes; and a controller configured to be capable of: (i) storing failure data in the memory together with an occurrence time of the failure contained in the failure information when the failure occurs in the substrate processing apparatus, the failure data containing first apparatus-related information reported before the failure during a first period defined in advance and the recipe in the memory; and (ii) adding second apparatus-related information reported after the failure during a second period defined in advance to the failure data.

### [Advantageous Effects]

According to some embodiments of the present disclosure, it is possible to rapidly identify a cause of an occurrence of a failure and supporting a recovery.

### [Brief Description of Drawings]

FIG. 1 is a diagram schematically illustrating a perspective view of a substrate processing apparatus preferably used in one or more embodiments of the present disclosure.
FIG. 2 is a diagram schematically illustrating a cross-section of a side portion of the substrate processing apparatus preferably used in the embodiments of the present disclosure.
FIG. 3 is a diagram schematically illustrating a functional configuration of a control system preferably used in the embodiments of the present disclosure.
FIG. 4 is a flow chart schematically illustrating a logic of a failure analysis process according to the embodiments of the present disclosure.
FIG. 5 is a flow chart schematically illustrating a logic of an apparatus information update process according to the embodiments of the present disclosure.
FIG. 6 is a flow chart schematically illustrating a logic of a failure information confirmation process according to the embodiments of the present disclosure.
FIG. 7 is a diagram schematically illustrating an example of apparatus information according to the embodiments of the present disclosure.
FIG. 8 is a diagram schematically illustrating an example of failure information according to the embodiments of the present disclosure.
FIG. 9 is a diagram schematically illustrating an example of failure data according to the embodiments of the present disclosure.
FIG. 10 is a diagram schematically illustrating an example of time series of the apparatus information according to the embodiments of the present disclosure.
FIG. 11 is a diagram schematically illustrating an example of a failure data display screen according to the embodiments of the present disclosure.
FIG. 12 is a diagram schematically illustrating another example of an elapsed time information display region according to the embodiments of the present disclosure.
FIG. 13 is a diagram schematically illustrating an example of a recipe download history according to the embodiments of the present disclosure.
FIG. 14 is a diagram schematically illustrating another example of a failure information display region according to the embodiments of the present disclosure.
FIG. 15 is a diagram schematically illustrating the apparatus information, first apparatus-related information and second apparatus-related information.

### [Detailed Description]

### <Embodiments of Present Disclosure>

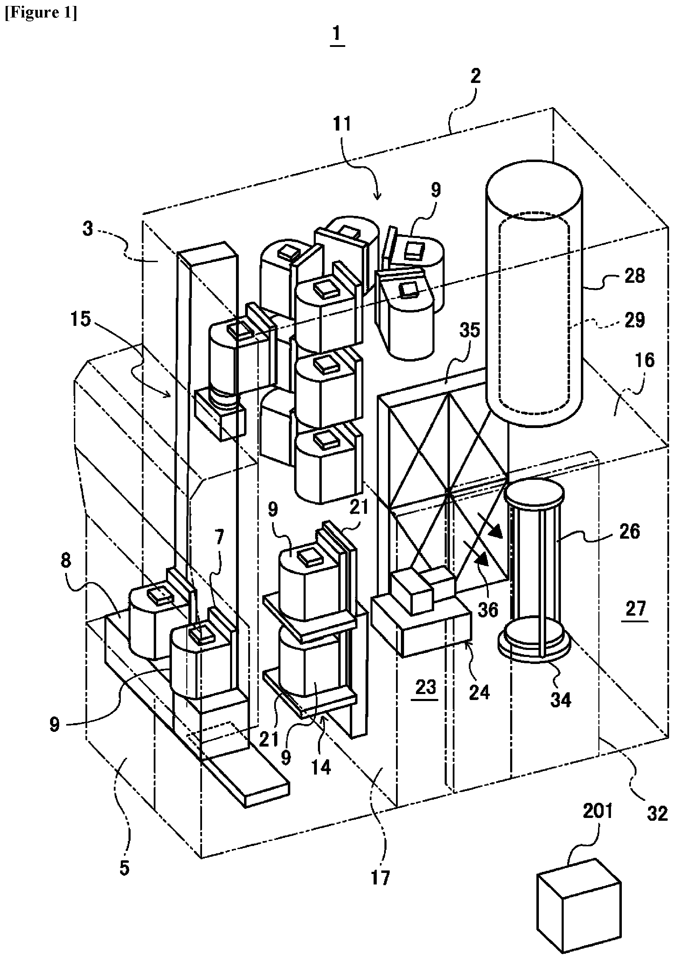

Hereinafter, one or more embodiments (also simply referred to as "embodiments") of the technique of the present disclosure will be described in detail mainly with reference to FIGS. 1 through 14. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match.

### <Overview of Substrate Processing Apparatus>

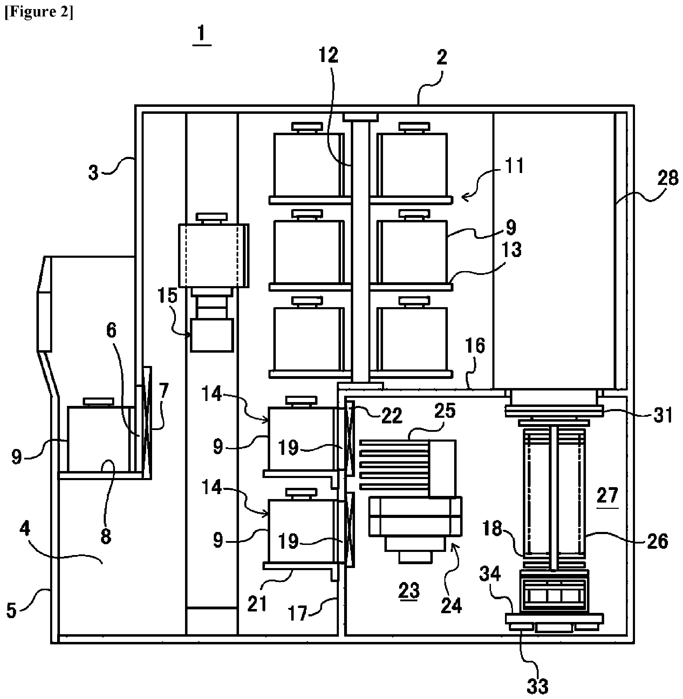

Hereinafter, the embodiments of the technique of the present disclosure will be described with reference to the drawings. First, a substrate processing apparatus 1 in which the technique of the present disclosure is implemented will be described with reference to FIGS. 1 and 2.

The substrate processing apparatus 1 includes a housing 2. A front maintenance port 4 serving as an opening provided for maintenance is provided at a lower portion of a front wall 3 of the housing 2. The front maintenance port 4 may be opened or closed by a front maintenance door 5.

A pod loading/unloading port 6 is provided at the front wall 3 of the housing 2 so as to communicate with an inside and an outside of the housing 2. The pod loading/unloading port 6 may be opened or closed by a front shutter 7. A loading port (which is a loading port shelf) 8 is provided in front of the pod loading/unloading port 6. The loading port 8 is configured such that a pod 9 is aligned while placed on the loading port 8.

The pod 9 is a sealed type substrate transfer container. The pod 9 may be transferred (or loaded) into and placed on the loading port 8 by an in-process transfer apparatus (not shown) and transferred (unloaded) out of the loading port 8 by the in-process transfer apparatus.

A rotatable pod shelf 11 is provided in the housing 2 to be located over a substantially center portion of the housing 2 in a front-rear direction. The rotatable pod shelf 11 is configured such that a plurality of pods including the pod 9 can be stored (or placed) on the rotatable pod shelf 11. Hereinafter, the plurality of pods including the pod 9 may also be simply referred to as "pods 9".

The rotatable pod shelf 11 includes a vertical support column 12 capable of rotating intermittently and a plurality of shelf plates 13. The plurality of shelf plates 13 are configured to be supported (or fixed) radially by the vertical support column 12 at positions of an upper portion, a lower portion and a mid portion of the vertical support column 12. Each of the plurality of shelf plates 13 is configured to accommodate a plurality of pods comprising the pod 9 when placed thereon.

A pod opener 14 is provided below the rotatable pod shelf 11. The pod opener 14 is provided with a configuration on which the pod 9 is placed and capable of opening and closing a lid of the pod 9.

A pod transfer structure (which is a container transfer structure) 15 is provided among the loading port 8, the rotatable pod shelf 11 and the pod opener 14. The pod transfer structure 15 is configured such that the pod 9 is capable of being elevated and lowered and being moved forward and backward in a horizontal direction while being supported by the pod transfer structure 15, and such that the pod 9 is capable of being transferred among the loading port 8, the rotatable pod shelf 11 and the pod opener 14.

A sub-housing 16 is provided below the substantially center portion of the housing 2 in the front-rear direction toward a rear end of the substrate processing apparatus 1. A pair of substrate loading/unloading ports 19 configured to load or unload a wafer (hereinafter, also referred to as a "substrate") 18 into or out of the sub-housing 16 is provided at a front wall 17 of the sub-housing 16. The pair of substrate loading/unloading ports 19 is arranged vertically in two stages. A pair of pod openers including the pod opener 14 are provided at the pair of substrate loading/unloading ports 19, respectively. For example, an upper pod opener and a lower pod opener may be provided as the pair of pod openers. The upper pod opener and the lower pod opener may be collectively or individually referred to as the "pod opener 14".

The pod opener 14 may include: a placement table 21 where the pod 9 is placed thereon; and a cap attaching/detaching structure 22 capable of attaching and detaching the lid of the pod 9. The pod opener 14 is configured such that a substrate entrance of the pod 9 is opened or closed by detaching or attaching the lid of the pod 9 placed on the placement table 21 by the cap attaching/detaching structure 22.

The sub-housing 16 defines a transfer chamber 23 fluidically isolated from a space (hereinafter, also referred to as a "pod transfer space") in which the pod transfer structure 15 or the rotatable pod shelf 11 is provided. A substrate transfer structure 24 is provided at a front region of the transfer chamber 23. The substrate transfer structure 24 may include a predetermined number of substrate mounting plates (for example, as shown in FIG. 2, five substrate mounting plates) 25 on which a predetermined number of substrates including the substrate 18 are placed. Each of the substrate mounting plates 25 is capable of being moved directly in the horizontal direction, being rotated in the horizontal direction and being elevated or lowered in a vertical direction. The substrate transfer structure 24 is configured such that the substrate 18 is capable of being loaded into or unloaded out of a boat 26.

In a rear region of the transfer chamber 23, a standby space 27 where the boat 26 is accommodated and in standby is provided, and a process furnace 28 such as a vertical type process furnace is provided above the standby space 27. A process chamber 29 is provided inside the process furnace 28, and a lower end portion of the process chamber 29 is configured as a furnace opening. The furnace opening is opened or closed by a furnace opening shutter 31. The process furnace 28 serves as an example of a process vessel.

A boat elevator 32 capable of elevating and lowering the boat 26 is provided between a right end of the housing 2 and a right end of the standby space 27 of the sub-housing 16. A seal cap 34 serving as a lid is horizontally attached to an arm 33 connected to an elevating platform of the boat elevator 32. The seal cap 34 is configured such that the boat 26 can be vertically supported by the seal cap 34, and such that the furnace opening can be airtightly closed by the seal cap 34 while the boat 26 is loaded into the process chamber 29.

The boat 26 is configured such that a plurality of substrates including the substrate 18 are supported on the boat 26 in a horizontal orientation in a multistage manner with their centers aligned with one another. Hereinafter, the plurality of substrates including the substrate 18 may also be simply referred to as "substrates 18".

A clean air supply structure 35 is arranged at a position facing the boat elevator 32. The clean air supply structure 35 is constituted by a supply fan and a dustproof filter so as to supply clean air 36 such as an inert gas and a clean atmosphere. A notch alignment device (not shown) serving as a substrate alignment device configured to align a circumferential position of the substrate 18 is provided between the substrate transfer structure 24 and the clean air supply structure 35.

The clean air 36 ejected from the clean air supply structure 35 is circulated in components such as the notch alignment device (not shown), the substrate transfer structure 24 and the boat 26. Thereafter, the clean air 36 is exhausted out of the housing 2 through a duct (not shown), or is ejected again into the transfer chamber 23 by the clean air supply structure 35.

Subsequently, an operation of the substrate processing apparatus 1 will be described.

When the pod 9 is supplied to the loading port 8, the pod loading/unloading port 6 is opened by the front shutter 7. Then, the pod 9 placed on the loading port 8 is transferred (loaded) into the housing 2 through the pod loading/unloading port 6 by the pod transfer structure 15, and is placed on a designated shelf plate among the plurality of shelf plates 13 of the rotatable pod shelf 11. The pod 9 is temporarily stored in the rotatable pod shelf 11. Then, the pod 9 is transferred from the designated shelf plate 13 to the placement table 21 of the pod opener 14 (that is, one of the upper pod opener and the lower pod opener) by the pod transfer structure 15. Alternatively, the pod 9 may be transferred directly from the loading port 8 to the placement table 21 of the pod opener 14.

When the pod 9 is being transferred, the substrate loading/unloading ports 19 are closed by the cap attaching/detaching structure 22, and the transfer chamber 23 is filled with the clean air 36. For example, the transfer chamber 23 is filled with nitrogen gas serving as the clean air 36 such that an oxygen concentration in the transfer chamber 23 is set to 20 ppm or less, which is much lower than an oxygen concentration in the housing 2 (which is an atmospheric atmosphere).

When an end surface of the pod 9 placed on the placement table 21 is pressed against an opening edge of one of the pair of substrate loading/unloading ports 19 of the front wall 17 of the sub-housing 16, the cap attaching/detaching structure 22 detaches the lid of the pod 9 and the substrate entrance of the pod 9 is opened.

When the pod 9 is opened by the pod opener 14 (that is, one of the upper pod opener and the lower pod opener), the substrate 18 is then taken out from the pod 9 by the substrate transfer structure 24, transferred to the notch alignment device (not shown), and aligned by the notch alignment device. Then, by the substrate transfer structure 24, the substrate 18 is transferred (or loaded) into the standby space 27 provided in the rear region of the transfer chamber 23, and loaded (or charged) into the boat 26.

After the substrate 18 is charged into the boat 26, the substrate transfer structure 24 then returns to the pod 9 and transfers a next substrate among the substrates 18 from the pod 9 into the boat 26.

While the substrate transfer structure 24 loads the substrates 18 into the boat 26 through the pod opener 14 (which is one of the upper pod opener and the lower pod opener), another pod 9 is transferred from the rotatable pod shelf 11 by the pod transfer structure 15 to the pod opener 14 (which is the other one of the upper pod opener and the lower pod opener), and the lid of the aforementioned another pod 9 is opened by the other one of the upper pod opener and the lower pod opener.

When the substrates 18 are charged into the boat 26, the furnace opening of the process furnace 28 closed by the furnace opening shutter 31 is opened by the furnace opening shutter 31. Subsequently, the boat 26 accommodating the substrates 18 is elevated by the boat elevator 32 such that the boat 26 is loaded (inserted) into the process chamber 29.

After the boat 26 is loaded, the furnace opening is airtightly closed by the seal cap 34. Further, according to the present embodiments, at this timing (that is, after the boat 26 is loaded), a purge step (also referred to as a "pre-purge step") of replacing an inner atmosphere of the process chamber 29 with the inert gas is performed.

The process chamber 29 is vacuum-exhausted by a gas exhaust structure (which is a gas exhauster) (not shown) such that an inner pressure of the process chamber 29 reaches and is maintained at a desired pressure (vacuum degree). Further, the process chamber 29 is heated to a predetermined temperature by a heater driver (not shown) such that a desired temperature distribution of the process chamber 29 is obtained.

Further, a process gas whose flow rate is controlled to a predetermined flow rate is supplied by a gas supply structure (which is a gas supplier) (not shown), and the process gas comes into contact with a surface of the substrate 18 while flowing through the process chamber 29. Thereby, a predetermined processing such as a substrate processing described later is performed on the surface of the substrate 18. Further, the process gas after a reaction of the predetermined processing is exhausted from the process chamber 29 by the gas exhaust structure.

After a predetermined process time has elapsed, the inert gas is supplied from an inert gas supply source (not shown) by the gas supply structure, the inner atmosphere of the process chamber 29 is replaced with the inert gas, and the inner pressure of the process chamber 29 is returned to the normal pressure (after-purge step). Then, the boat 26 is lowered by the boat elevator 32 through the seal cap 34. I n the present specification, the process time may refer to a time duration of continuously performing a process related thereto. The same also applies to the following description.

After the substrate 18 is processed, the substrate 18 and the pod 9 are transferred (unloaded) out of the housing 2 in an order reverse to that of loading the substrate 18 and the pod 9 into the housing 2 described above. Then, an unprocessed substrate 18 is further loaded into the boat 26, and a batch processing of the substrate 18 is repeatedly performed.

### <Functional Configuration of Control System>

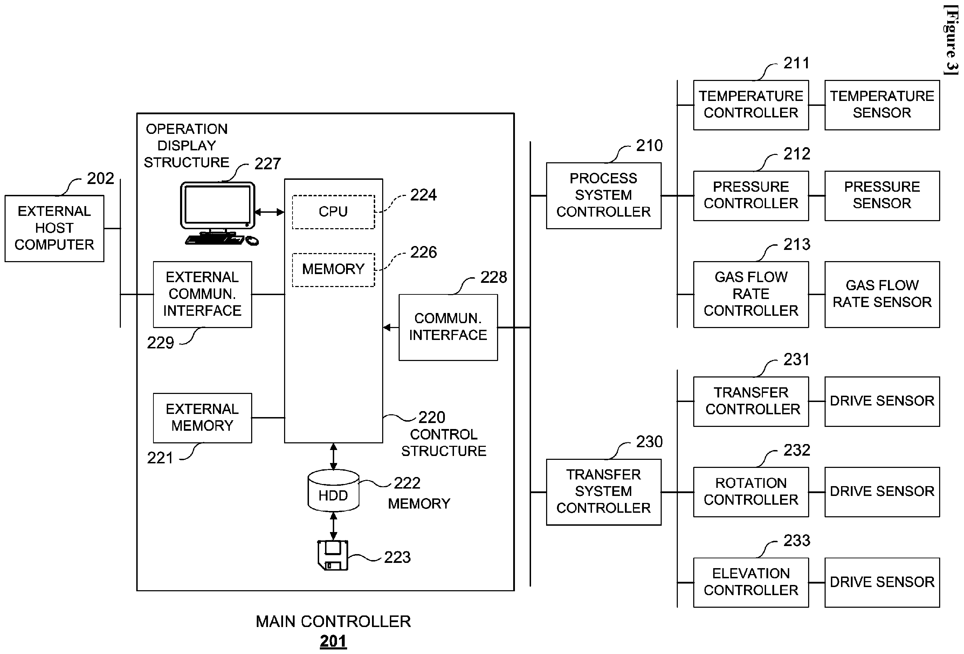

Subsequently, a functional configuration of a control system centered on a main controller 201 will be described with reference to FIG. 3. As shown in FIG. 3, the control system includes the main controller 201, a process system controller 210 and a transfer system controller 230. Further, the main controller 201 functions as a data collection controller. The main controller 201 is configured to collect apparatus data generated by the substrate processing apparatus 1 and to monitor a data integrity of the apparatus data.

According to the present embodiments, the apparatus data may contain apparatus information generated by an operation of a component constituting the substrate processing apparatus 1 (for example, a component such as a quartz reaction tube, a heater, a valve and an MFC) when the substrate 18 is processed by the substrate processing apparatus 1. For example, the apparatus information may contain: data (for example, an actually measured value) related to the substrate processing such as a process temperature, a process pressure and the flow rate of the process gas when the substrate processing apparatus 1 processes the substrate 18; data related to a quality of a product substrate (for example, data such as a thickness of a film and an accumulated thickness of the film); and data related to the component constituting the substrate processing apparatus 1 (for example, data such as a pre-set value, an actually measured value, the number of times the component is used and a usage time of the component). The apparatus data may further contain event data related to various apparatus events generated by the substrate processing apparatus 1. For example, the event data may contain alarm information for generating various alarms. In the present specification, the process temperature may refer to a temperature of the wafer 18 or an inner temperature of the process chamber 29, and the process pressure may refer to the inner pressure of the process chamber 29. Further the process gas may refer to a gas supplied so as to perform the predetermined processing on the surface of the wafer 18 in the process chamber 29. The same also applies to the following description.

Further, data collected when a recipe is executed may also be referred to as "process data". The process data may contain: actually measured value data collected at a predetermined time interval (for example, raw waveform data collected from a start to an end of the recipe at the predetermined time interval such as 1 second); and statistical data created by processing the actually measured value data collected with the predetermined time interval at each step in the recipe. The apparatus data may also contain the process data. Further, the statistical data may also contain values such as a maximum value, a minimum value and an average value. The apparatus data may also contain the event data indicating various apparatus events generated during an idling period when the recipe is not executed (for example, when the substrate 18 is not loaded into the substrate processing apparatus 1). For example, the event data may contain data indicating a maintenance history.

Further, for example, the apparatus data may further contain transfer data generated when the substrate 18 is transferred.

For example, the main controller 201 is electrically connected to the process system controller 210 and the transfer system controller 230 by a LAN (Local Area Network) such as 100 BASE-T. Therefore, each apparatus data can be transmitted or received and each file can be uploaded or downloaded among the main controller 201, the process system controller 210 and the transfer system controller 230.

For example, the main controller 201 is provided with an external memory 221 serving as a mounting structure where a recording medium such as a USB memory serving as an external memory device is installed or removed. Further, for example, an external communication interface 229 capable of being connected to an external host computer 202 via a communication network is provided at the main controller 201. Therefore, even when the substrate processing apparatus 1 is installed in a clean room, an external host computer 202 can be arranged in a location such as an office outside the clean room. Further, the external host computer 202 may be configured to be connected to the substrate processing apparatus 1 by a LAN line and to collect the apparatus data from the main controller 201.

The main controller 201 is configured to be capable of collecting the apparatus data, quantifying an operating state of the apparatus (that is, the substrate processing apparatus 1) and displaying the quantified operating state on a screen. Further, the main controller 201 is configured to be capable of executing each function described later. The main controller 201 will be described later in detail.

The process system controller 210 is configured to report the process data which is process system information containing at least one among an inner temperature of the process furnace 28, the gas within the process furnace 28 and an inner pressure (pressure information) of the process furnace 28. Specifically, the process system controller 210 contains a temperature controller 211, a pressure controller 212 and a gas flow rate controller 213. The temperature controller 211, the pressure controller 212 and the gas flow rate controller 213 described above constitute sub-controllers, and are electrically connected to the process system controller 210. Therefore, each apparatus data can be transmitted or received and each file can be uploaded or downloaded among the process system controller 210, the temperature controller 211, the pressure controller 212 and the gas flow rate controller 213. Although the process system controller 210 and the sub-controllers thereof are shown separately, the process system controller 210 and the sub-controllers thereof may be implemented as an integrated structure.

The transfer system controller 230 is configured to report the transfer data which is transfer system information for transferring the substrate 18. Specifically, the transfer system controller 230 includes a transfer controller 231, a rotation controller 232 and an elevation controller 233. The transfer controller 231, the rotation controller 232 and the elevation controller 233 described above constitute sub-controllers, and are electrically connected to the transfer system controller 230. Therefore, each apparatus data can be transmitted or received and each file can be uploaded or downloaded among the transfer system controller 230, the transfer controller 231, the rotation controller 232 and the elevation controller 233. Although the transfer system controller 230 and the sub-controllers thereof are shown separately, the transfer system controller 230 and the sub-controllers thereof may be implemented as an integrated structure.

A drive sensor capable of controlling the pod transfer structure 15 is connected to the transfer controller 231. The transfer controller 231 is configured to be capable of controlling an operation of the pod transfer structure 15.

A drive sensor capable of controlling the rotatable pod shelf 11 is connected to the rotation controller 232. The rotation controller 232 is configured to be capable of controlling an operation of the rotatable pod shelf 11.

A drive sensor capable of controlling the boat elevator 32 is connected to the elevation controller 233. The elevation controller 233 is configured to be capable of controlling an operation of the boat elevator 32.

For example, the heater and a temperature sensor are connected to the temperature controller 211. The temperature controller 211 is configured to be capable of adjusting the inner temperature of the process furnace 28 by controlling a temperature of the heater of the process furnace 28. Further, the temperature controller 211 is configured to be capable of controlling the electric power supplied to a heater wire by controlling a switching (which is an on / off control) of a thyristor.

For example, a pressure sensor, an APC valve (not shown) serving as a pressure valve and a vacuum pump (not shown) is connected to the pressure controller 212. The pressure controller 212 is configured to be capable of controlling an opening degree of the APC valve and a switching (which is an on / off control) of the vacuum pump based on a pressure value detected by the pressure sensor such that the inner pressure of the process chamber 29 reaches a desired pressure at a desired timing.

The gas flow rate controller 213 is constituted by the MFC, and connected to a gas flow rate sensor.

In addition to performing respective control operations described above, each of the process system controller 210 and the transfer system controller 230 is configured to report a status, failure information indicating a failure detected based on sensor information and a value of each sensor connected thereto to the main controller 201 in real time as the apparatus information.

According to the present embodiments, each of the main controller 201, the process system controller 210 and the transfer system controller 230 may be embodied by a general computer system instead of a dedicated computer system. For example, by installing in the general computer system a program for executing the predetermined processing described above from a recording medium such as a flexible disk, a CD-ROM and a USB memory storing the program, each controller described above may be provided to perform the predetermined processing.

Further, a method of supplying the program can be appropriately selected. Instead of or in addition to being supplied through a predetermined recording medium as described above, for example, the program may be provided through a communication line, a communication network or a communication system. In such a case, for example, the program may be posted on a bulletin board on the communication network, and may be provided by being superimposed on a carrier wave via the communication network. Further, the program provided as described above may be executed to perform the predetermined processing described above under a control of an OS (operating system) of the substrate processing apparatus 1 just like any other application programs.

### <Configuration of Main controller 201>

Subsequently, a configuration of the main controller 201 will be described with reference to FIG. 3.

The main controller 201 may include a control structure (controller) 220 of the main controller 201, a memory (which is a hard disk drive) 222 of the main controller 201, an operation display structure 227 including a display capable of displaying various information and an input structure capable of accepting (receiving) various instructions from an operating personnel; a communication interface 228 of the main controller 201 capable of communicating with components inside and outside the substrate processing apparatus 1; the external communication interface 229 capable of communicating with components outside the substrate processing apparatus 1; and the external memory 221 capable of being connected to the recording medium. In the present specification, in addition to an apparatus operating personnel, the operating personnel may further include an apparatus manager, an apparatus engineer, a maintenance personnel and a worker. The control structure 220 of the main controller 201 may be embodied by a computer including: a CPU (Central Processing Unit) 224 serving as a processor, a memory 226 such as a RAM (Random Access Memory) and a ROM (Read Only Memory) serving as a temporary memory. The computer constituting the control structure 220 of the main controller 201 is further provided with a clock function (not shown).

In the memory 222, a recipe file such as a recipe in which process conditions and process sequences of the substrate processing are defined, a control program file for executing the recipe file, a parameter file in which parameters for executing the recipe are defined, an error processing program file, a parameter file for an error processing, various screen files including an input screen for inputting process parameters and various icon files and the like (which are not shown) are stored (or saved).

Further, in the memory 222, the apparatus information containing the sensor information output from each controller described above and the failure information indicating the failure detected by each controller based on the sensor information are stored. Further, in the memory 222, failure data and updated apparatus information, which will be described later, are stored.

Further, on an operation screen of the operation display structure 227, operation buttons serving as the input structure through which an operation instruction to a substrate transfer system or a substrate processing system is input may be provided.

The operation display structure 227 is configured to be capable of displaying the operation screen for operating the substrate processing apparatus 1. The operation display structure 227 is configured to be capable of displaying information on the operation screen of the operation display structure 227, based on the apparatus data generated in the substrate processing apparatus 1 via the operation screen. For example, the operation screen of the operation display structure 227 may be constituted by a touch panel using a liquid crystal display. The operation display structure 227 is configured to accept (receive) input data (input instruction) of the operating personnel via the operation screen and to transmit the input data to the main controller 201. Further, the operation display structure 227 is configured to be capable of accepting (receiving) an instruction (control instruction) for executing a recipe stored in the memory (such as the RAM) 226 and the like or an appropriate substrate processing recipe (also referred to as a "process recipe") among a plurality of recipes stored in the memory 222, and capable of transmitting the instruction (control instruction) to the control structure 220.

The communication interface 228 is connected to a component such as a switching hub. The main controller 201 is configured to be capable of transmitting and receiving various data to and from an external computer or another controller (that is, the process system controller 210, the temperature controller 211, the pressure controller 212, the gas flow rate controller 213, the transfer system controller 230, the transfer controller 231, the rotation controller 232 and the elevation controller 233) in the substrate processing apparatus 1 via a network such as the LAN.

When the failure occurs, the control structure 220 performs a control operation of storing in the memory 222 the failure data containing the apparatus information reported when the failure occurs, the updated apparatus information reported before the failure during a first period defined in advance and the recipe together with an occurrence time of the failure. The control structure 220 further performs a control operation of adding the updated apparatus information reported after the failure during a second period defined in advance to the failure data. In the present embodiments, the updated apparatus information during the first period serves an example of first apparatus-related information, and the updated apparatus information during the second period serves an example of second apparatus-related information.

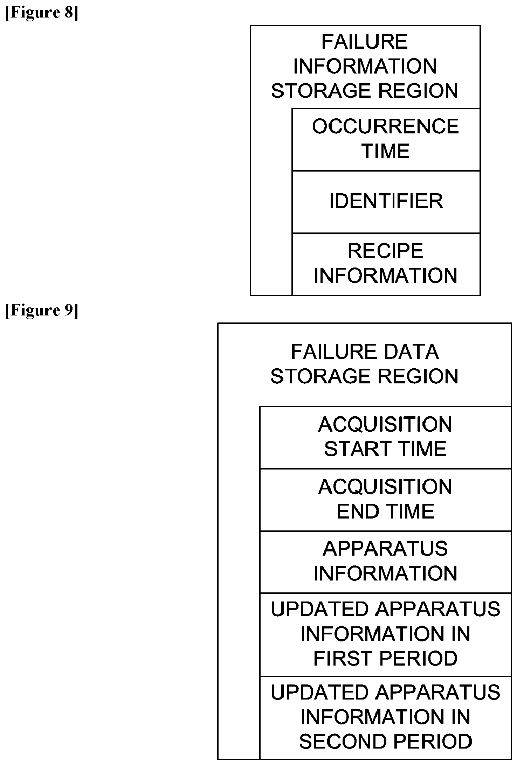

Specifically, the control structure 220 creates the failure information (see FIG. 8) and the failure data (see FIG. 9) based on the apparatus information reported from the process system controller 210 or the transfer system controller 230 (which are lower controllers) when the failure occurs.

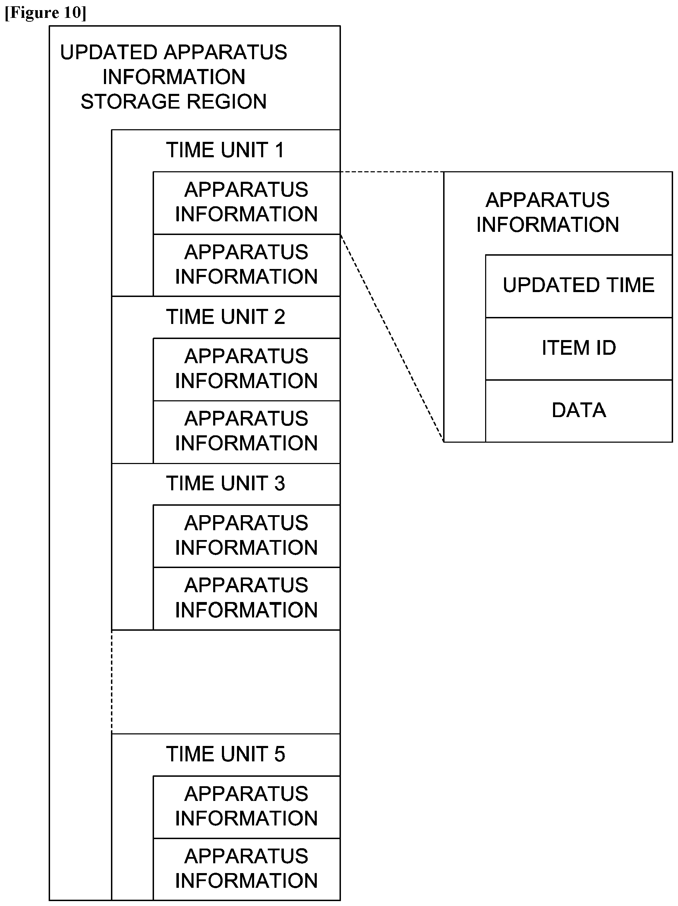

In addition, after the failure occurs, the control structure 220 adds to the failure data (see FIG. 9) the updated apparatus information (see FIG. 10) after an end time of the second period designated in advance is reached.

FIG. 8 is a diagram schematically illustrating an example of the failure information according to the present embodiments is stored in a failure information storage region of the memory 222. In FIG. 8, an example in which the failure information is constituted by the occurrence time of the failure, an identifier and recipe information is shown. FIG. 9 is a diagram schematically illustrating an example of the failure data according to the present embodiments is stored in a failure data storage region of the memory 222. In FIG. 9, an example in which the failure data is constituted by an acquisition start time, an acquisition end time, the apparatus information (which is initial data), the updated apparatus information in the first period (which is additional data) and the updated apparatus information in the second period (which is additional data) is shown. FIG. 10 is a diagram schematically illustrating an example of the apparatus information stored in an updated apparatus information storage region of the memory 222. In FIG. 10, an example in which the updated apparatus information is constituted by the apparatus information at each time is shown.

More specifically, when the occurrence time of the failure is indicated by "T", the acquisition start time is indicated by "T-a", and the acquisition end time is indicated by "T+a". The apparatus information (which is the initial data) is an entirety of the apparatus information at time T-a, and the updated apparatus information (which is the additional data) is the apparatus information changed from the time T-a to the time T+a.

Further, in the present specification, a notation of a numerical range such as "from T-a to T+a" means that a lower limit and an upper limit are included in the numerical range. Therefore, for example, a numerical range "from T-a to T+a" means a range equal to or higher than T-a and equal to or lower than T+a. The same also applies to other numerical ranges described herein.

Further, the control structure 220 is configured to constantly perform a process of storing and organizing the entirety of the apparatus information at the time T-a in the memory 222 as the apparatus information (which is the initial data). For example, the apparatus information stored in the memory 222 is updated using the apparatus information in a case where the first period corresponding to "a" seconds has passed after being reported. As a result, the entirety of the apparatus information at the time T-a can be always stored in the memory 222 as the apparatus information (which is the initial data). Further, the control structure 220 is configured to add the apparatus information (that is, the updated apparatus information) to the failure data in a case where the second period corresponding to "a" seconds has passed after being reported. As a result, it is possible to add the updated apparatus information (which is the additional data) in the second period to the failure data.

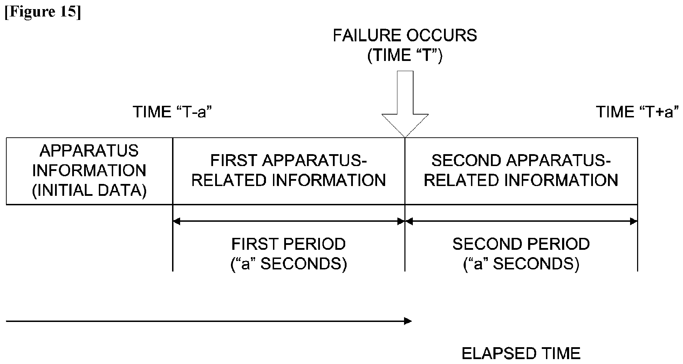

In the present application, unless otherwise specified, the "apparatus information (which is the initial data)", that is, the entirety of the apparatus information (apparatus data) at the time T-a, may also be simply referred to as "apparatus information". The first apparatus-related information and the second apparatus-related information may be different from the "apparatus information" (initial information). FIG. 15 is a diagram schematically illustrating the apparatus information, the first apparatus-related information and the second apparatus-related information. More specifically, "apparatus information" (initial information) may refer to the apparatus data earlier than the first period (i.e., "a" seconds) before the time when the failure occurs, that is, up to "time (T-a)". The first apparatus-related information may refer to the apparatus data during the first period when the failure occurs, that is, a period from (T-a) to T. The second apparatus-related information may refer to the apparatus data during the second period after the failure occurs, that is, a period from T to (T+a). Accordingly, for example, the "apparatus information" and the "first apparatus-related information" exist in the memory 222 at the time when the failure occurs.

As described above, according to the present embodiments, the apparatus information contains the process system information including the inner temperature of the process furnace 28, the gas within the process furnace 28 and the inner pressure (pressure information) of the process furnace 28 and the transfer system information for transferring the substrate 18. However, the entirety of the apparatus information may not be stored every second, but a part of the apparatus information that changed may be stored. That is, the stored process system information represents information reported when there is a change in at least one of temperature, gas and pressure. In addition, the stored transfer system information represents information reported when there is a change in the operations of the mechanical structures of the substrate processing apparatus. In this manner, the amount of data to be stored can be suppressed.

Further, the operation display structure 227 is configured to be capable of displaying the failure data.

Further, the operation display structure 227 is configured such that the first period and the second period can be set by parameters. As a result, when the failure occurs, the control structure 220 obtains the updated apparatus information in the first period and the updated apparatus information in the second period by referring to the first period and the second period set by the parameters. In a manner described above, it is possible to adjust an amount of the updated apparatus information in the first period and an amount of updated apparatus information in the second period for identifying (or specifying) a cause of an occurrence of the failure.

Further, the operation display structure 227 is configured to be capable of displaying the recipe, the apparatus information and the failure information in the first period before the failure and the second period after the failure on the same screen.

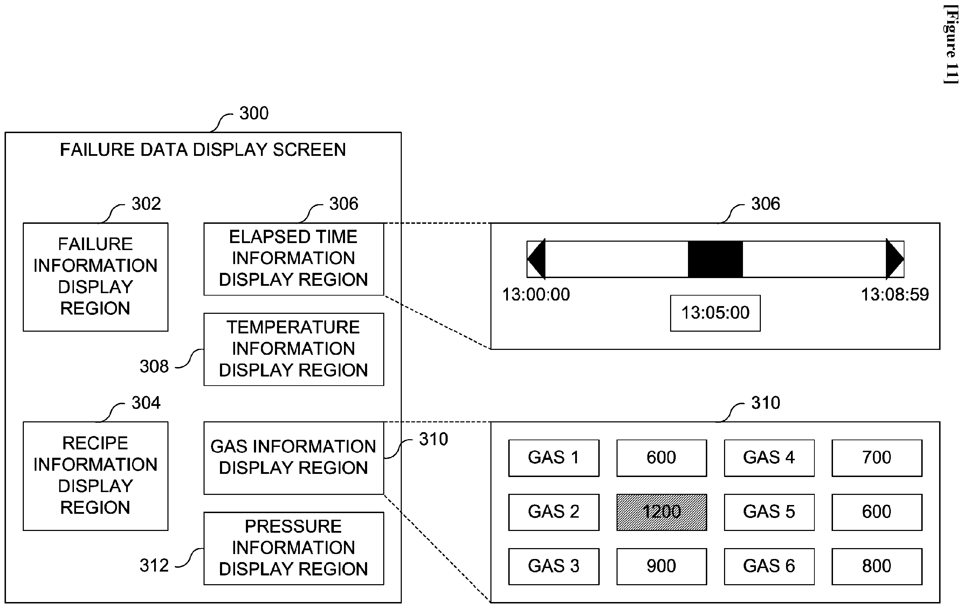

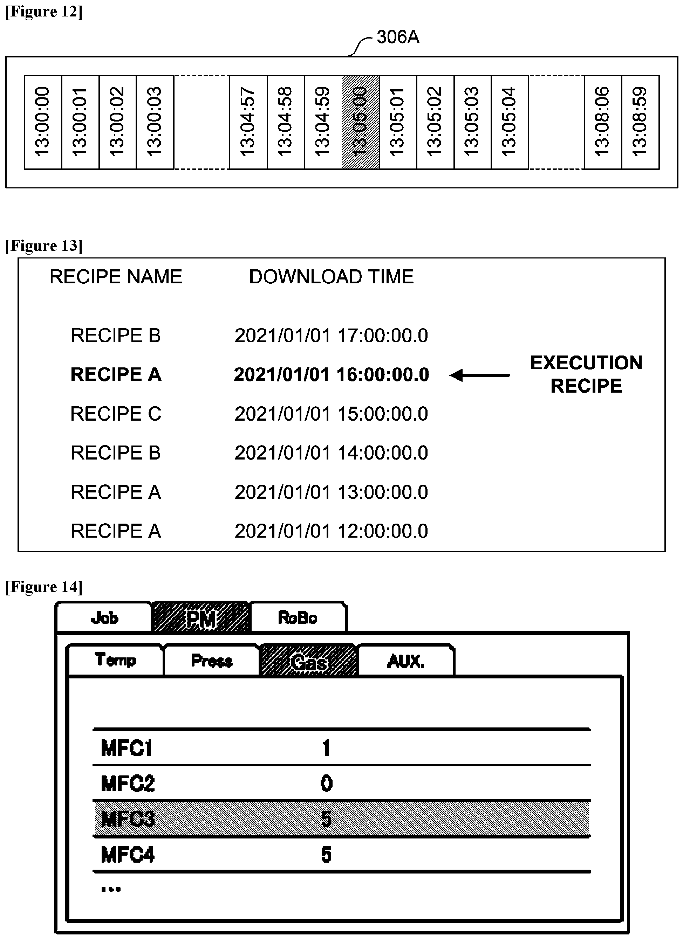

Specifically, as shown in FIG. 11, a failure data display screen 300 may include a failure information display region 302, a recipe information display region 304 configured to display recipes for the first period and the second period and an elapsed time information display region 306. In addition, the failure data display screen 300 may include a temperature information display region 308 configured to display temperature information in the first period and the second period, a gas information display region 310 configured to display gas information in the first period and the second period and a pressure information display region 312 configured to display the pressure information in the first period and the second period. More specifically, the elapsed time information display region 306 is provided with a slider bar, and is configured to accept (receive) an operation of the slider bar and to shift a display time of the failure information. The failure data display screen 300 shown in FIG. 11 is merely an example, and the present embodiments are not limited thereto. Alternatively, as shown in FIG. 12, an elapsed time information display region 306A configured to display each time may be used. Further, the gas information display region 310 is configured to display a gas flow rate detected by each gas flow rate sensor.

When the operation of the slider bar in the elapsed time information display region 306 is accepted (received), a position of the slider bar and a time of the apparatus information to be displayed are synchronized. A method of shifting the apparatus information corresponding to a target time (desired time) is performed by moving data between the initial data and the additional data. In a manner described above, it is possible to display the apparatus information of the time for identifying the cause of the occurrence of the failure with a simple operation.

For example, the operation display structure 227 is further configured to display a failure occurrence history list screen such that a selection of a designated (or specified) failure can be accepted. When the designated failure is selected, based on the occurrence time of the failure (that is, the designated failure) in the failure information, the control structure 220 acquires the failure data (which corresponds to the designated failure satisfying conditions that the acquisition start time is equal to or prior to the occurrence time of the failure and the occurrence time of the failure is prior to the acquisition end time, that is, the conditions "acquisition start time <= occurrence time of failure < acquisition end time") from the failure data accumulated in the memory 222, and the failure data display screen 300 is displayed.

For example, the operation display structure 227 is further configured to be capable of editing and confirming (or checking) pre-set contents of the recipe being executed at the time of the occurrence of the failure from the failure data display screen 300 or the failure occurrence history list screen. Thereby, it is possible to reduce the time and effort of searching for the recipe. In addition, even when the recipe is deleted, it is possible to confirm the deleted recipe. When a recipe setting mistake is found in the recipe, it is possible to edit the recipe as it is and to store (save) the recipe.

The function described above is realized by storing a recipe download history (see FIG. 13) together with a time stamp in the memory 222. In addition, in the recipe download history, the recipe designated (specified) when the substrate processing is executed and a start time of an execution of the substrate processing may be further stored in the memory 222.

Hereinafter, a method of acquiring execution recipe information will be described. When an execution recipe is downloaded from the control structure 220 to the lower controllers, the pre-set contents and a download time thereof are stored in the memory 222.

When the designated failure is selected from the failure data display screen 300 or the failure occurrence history list screen, based on the occurrence time of the failure (that is, the designated failure) in the failure information, the control structure 220 acquires the latest recipe (which corresponds to the designated failure satisfying conditions that the download time is prior to the occurrence time of the failure, that is, the conditions "download time < occurrence time of failure") among the recipes accumulated in the memory 222 as the execution recipe. Since the contents and the download time are accumulated in the memory 222 as the recipe download history, it is possible to refer to the pre-set contents at the time of the execution even when the recipe has already been edited or deleted.

For example, the operation display structure 227 may be further configured to be capable of switching a display of an occurrence location of a target failure (that is, the failure to be displayed). In such a case, the operation display structure 227 may preferentially display the failure data at the time of the occurrence of the failure. In a manner described above, it is possible to display information on the occurrence location of the failure for s identifying the cause of the occurrence of the failure or the failure data at the occurrence time of the failure with a simple operation.

For example, the control structure 220 may be further configured to identify the occurrence location of the failure from the information contained in the failure information, and the operation display structure 227 may be configured to preferentially display the occurrence location of the failure identified as described above and information related to the occurrence location of the failure. As a result, it is possible to rapidly identify the cause of the occurrence of the failure and it is also possible to support a recovery.

Specifically, the control structure 220 automatically extracts related data based on the identifier of the failure that has occurred. More specifically, by defining in advance individual identifiers of related apparatus information using the identifier of the failure that has occurred as a key, it is possible to extract the related data.

The data extracted in a manner described above may be displayed in the failure information display region 302 in the failure data display screen 300 of the operation display structure 227, for example, as a trace chart for 10 minutes before the occurrence of the failure. In such a case, failures, events and execution steps occurred during that period (that is, 10 minutes) are displayed as icons in a chronological order (time-series) at a bottom of the chart. By selecting each icon, detailed information linked and related to each icon may be displayed.

For example, as shown in FIG. 14, the operation display structure 227 is further configured to display a tab or a list related to the occurrence of the failure in the failure information display region 302 in a highlighted manner. As a result, since data with an abnormality can be confirmed (or checked) at a glance, it is possible to easily support an analysis described later.

The tab or the list related to the occurrence of the failure can be displayed in the highlighted manner by using a unique identifier assigned to each failure. As a failure definition file, identifiers of the failures associated with the data are defined in advance for each monitor screen and each display item in the screen. When displaying the failure data, the identifier of the failure information is acquired and compared with the failure definition file. A screen obtained as a result-related item and a display item in the screen are displayed in the highlighted manner.

In FIG. 14, an example in which a tab "PM", a tab "Gas" and an item "MFC3" in the list related to the occurrence of the failure are displayed in the highlighted manner is shown.

For example, the control structure 220 may be further configured to acquire the apparatus information in a third period related to an occurrence location of the identified failure, and may be further configured display the apparatus information in the third period on the operation display structure 227 in a chronological order (time-series). More specifically, by defining in advance individual identifiers of related apparatus information in the third period using the identifier of the occurrence location of the identified failure as a key, it is possible to extract the related apparatus information in the third period. In such a case, the operation display structure 227 may be further configured to accept (receive) a designated time from the apparatus information displayed in the chronological order, and may be further configured to display the recipe information related to the designated time. As a result, it is possible to rapidly identify the cause of the occurrence of the failure and it is also possible to support the recovery.

Further, the main controller 201 is configured to transmit the apparatus data such as a state of the substrate processing apparatus 1 to the external host computer 202 via the network (not shown). In addition, the substrate processing of the substrate processing apparatus 1 is controlled by the control system based on each recipe file, each parameter file and the like stored in the memory 222.

### <Substrate Processing Method>

Subsequently, a substrate processing method including a predetermined processing step, which is performed using the substrate processing apparatus 1 according to the present embodiments, will be described. The predetermined processing step will be described by way of an example in which the substrate processing such as a film-forming step (which is a part of a manufacturing process of a semiconductor device) is performed.

When performing the substrate processing, for example, the substrate processing recipe (that is, the process recipe) corresponding to the substrate processing to be performed is loaded into a memory such as RAM in the process system controller 210. Then, the operation instruction is appropriately transmitted from the main controller 201 to the process system controller 210. The substrate processing performed in such a manner may include at least a transfer step, a loading step, the film-forming step, an unloading step and a collection step.

### <Transfer Step>

The main controller 201 issues a drive instruction for the substrate transfer structure 24 to the transfer system controller 230. Then, while following the instruction from the transfer system controller 230, the substrate transfer structure 24 starts a transfer process of the substrate 18 from the pod 9 on the placement table 21 to the boat 26. The transfer process is performed until the substrates 18 scheduled to be loaded into the boat 26 are completely loaded into the boat 26.

### <Loading Step>

When the substrates 18 are completely loaded into the boat 26, the boat 26 is elevated by the boat elevator 32 which is operated in accordance with the instruction from the transfer system controller 230, and is loaded into the process chamber 29 provided in the process furnace 28 (boat loading). When the boat 26 is completely loaded into the process chamber 29, the seal cap 34 of the boat elevator 32 airtightly closes a lower end of a manifold of the process furnace 28.

### <Film-forming Step>

Thereafter, the inner atmosphere of the process chamber 29 is vacuum-exhausted by a vacuum exhaust apparatus such as the vacuum pump (not shown) in accordance with an instruction from the pressure controller 212 such that the inner pressure of the process chamber 29 reaches and is maintained at a predetermined process pressure (vacuum degree). In addition, the process chamber 29 is heated by the heater in accordance with an instruction from the temperature controller 211 such that the inner temperature of the process chamber 29 reaches and is maintained at a predetermined process temperature. Subsequently, the boat 26 and the substrates 18 accommodated in the boat 26 are rotated by a rotator (not shown) in accordance with an instruction from the transfer system controller 230. While the inner pressure of the process chamber 29 is maintained at the predetermined process pressure and the inner temperature of the process chamber 29 is maintained at the predetermined process temperature, a predetermined gas such as the process gas is supplied to the substrates 18 accommodated in the boat 26 in order to perform the predetermined processing (for example, a film-forming process) to the substrates 18.

### <Unloading Step>

After the film-forming step to the substrate 18 accommodated in the boat 26 is completed, the rotation of the boat 26 and the substrates 18 accommodated in the boat 26 by the rotator is stopped in accordance with an instruction from the transfer system controller 230. Then, the seal cap 34 is lowered by the boat elevator 32 such that the lower end of the manifold is opened. The boat 26 with the processed substrates 18 accommodated therein is then transferred (unloaded) out of the process furnace 28 (boat unloading).

### <Collection Step>

Thereafter, the boat 26 with the processed substrates 18 accommodated therein is very effectively cooled by the clean air 36 ejected from the clean air supply structure 35. For example, when the boat 26 is cooled to 150 °C or lower, the processed substrates 18 are transferred (discharged) from the boat 26 to the pod 9. Further, other unprocessed substrates 18 may be transferred to the boat 26.

### <Failure Analysis Process>

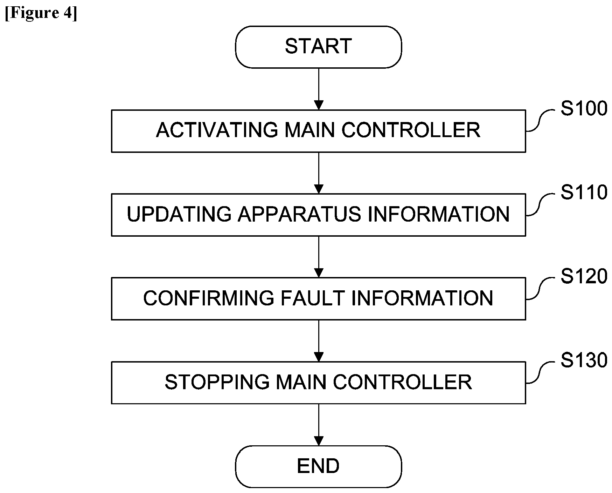

Subsequently, a process flow of a failure analysis process performed by the main controller 201 will be described mainly with reference to FIG. 4. The failure analysis process is repeatedly performed while the substrate processing apparatus 1 is in operation.

A process of storing (saving) the apparatus data for a predetermined number of seconds (the first period and the second period) before and after the failure will be described.

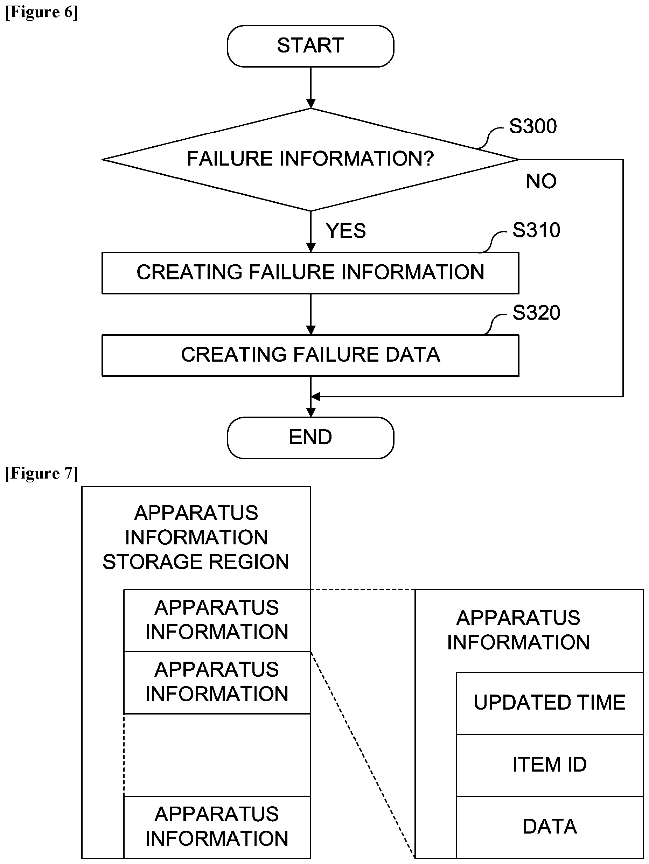

First, in a step S 100, the main controller 201 is activated. The control structure 220 of the main controller 201 records an entirety of current apparatus information in an associative array (see FIG. 7) when the main controller 201 is activated. Such information is referred to as the initial data. FIG. 7 is a diagram schematically illustrating an example in which the associative array of the apparatus information is stored in the apparatus information storage region of the memory 222.

Then, in a step S 110, the main controller 201 performs an apparatus information update process.

Then, in a step S120, the main controller 201 performs a failure information confirmation process.

In a step S130, the main controller 201 is stopped.

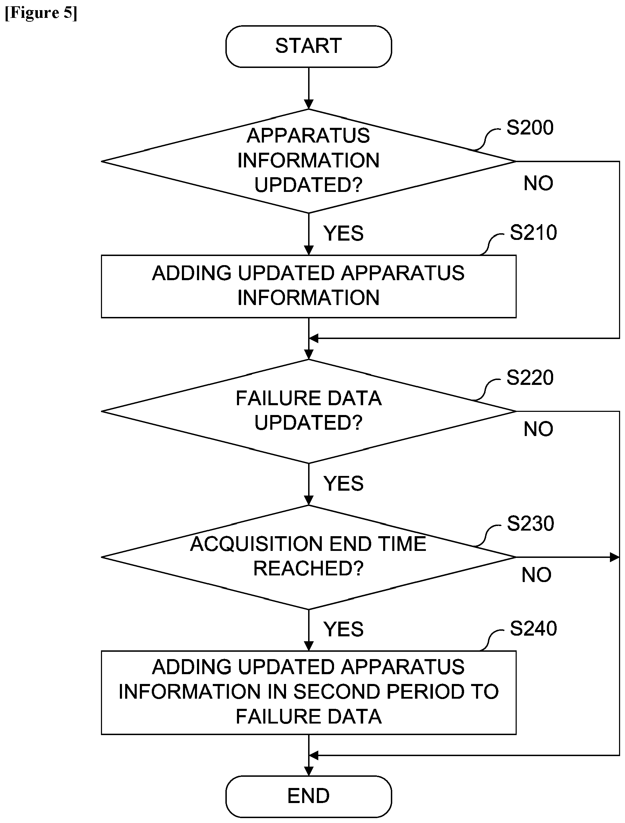

The apparatus information update process in the step S 110 will be described in detail based on a flow chart of the apparatus information update process shown in FIG. 5.

In a step S200, the control structure 220 constantly monitors a change in the apparatus information reported from the lower controllers (that is, the process system controller 210 and the transfer system controller 230), and determines whether or not there has been the change in the apparatus information. When there is no change in the apparatus information, it is determined not to update the apparatus information, and a step S220 is performed. On the other hand, when the apparatus information has changed, it is determined that the apparatus information should be updated, and a step S210 is performed.

In the step S210, the apparatus information (which is changed) is added to an array of the apparatus information in a chronological order (FIG. 10). Such information is referred to as the additional data. Further, the apparatus information reported to the lower controllers may also contain a time stamp representing a current time. During a normal operation (that is, when no failure occurs), the apparatus information for "a" seconds (that is, the first period) is stored in an array of the additional data.

When the apparatus information for "a" seconds (first period) or more is accumulated, surplus data (the apparatus information with the oldest date and time in the first period) is added to an array of the initial data (FIG. 7) (that is, when the same type already exists, it is overwritten). Thereby, the initial data is always updated to data "a" seconds before the current time.

In the step S220, it is determined whether or not to update the failure data. In a case where the failure occurs and the updated apparatus information in the second period has not yet been added to the failure data, it is determined that the failure data is to be updated, and a step S230 is performed. In such a case, the initial data (that is, the apparatus information) and the additional data (that is, the updated apparatus information in the first period) are stored in the failure data.

In the step S230, it is determined whether or not the acquisition end time has been reached. When the acquisition end time is reached, a step S240 is performed. On the other hand, when the acquisition end time has not been reached, the apparatus information update process is terminated. As a result, the updated apparatus information in the second period is updated until the acquisition end time is reached.

In the step S240, the updated apparatus information in the second period is added to the failure data, and the apparatus information update process is terminated. In such a case, since the failure data is data of a large size, the failure data may be compressed and stored in the memory 222.

The failure information confirmation process in the step S 120 will be described in detail based on a flow chart of the failure information confirmation process shown in FIG. 6.

In a step S300, the control structure 220 determines whether or not the failure has occurred. When no failure has occurred, the failure information confirmation process is terminated. On the other hand, when the failure has occurred, a step S310 is performed.

In the step S310, the control structure 220 creates the failure information based on information reported from the lower controllers.

In a step S320, the control structure 220 generates the failure data containing the failure information created in the step S310. When generating the failure data, the acquisition start time and the acquisition end time are calculated from the occurrence time of the failure, and the initial data (that is, the apparatus information) and the additional data (that is, the updated apparatus information in the first period) are stored in the failure data. Then, the failure information confirmation process is terminated.

When accepting (receiving) an operation to display the failure data, the operation display structure 227 displays the failure occurrence history list screen. When the designated failure is selected, based on the occurrence time of the failure (that is, the designated failure) in the failure information, the control structure 220 acquires the failure data (which corresponds to the designated failure) from the failure data accumulated in the memory 222, and the failure data display screen 300 is displayed as shown in FIG. 11.

Further, when the operation of the slider bar in the elapsed time information display region 306 is accepted (received) on the failure data display screen 300, the position of the slider bar and the time of the apparatus information to be displayed are synchronized by the operation display structure 227.

Further, when an operation of editing and confirming the pre-set contents of the recipe being executed when the failure has occurred is accepted (received) on the failure data display screen 300 or the failure occurrence history list screen, the operation display structure 227 displays the pre-set contents of the recipe being executed when the failure has occurred in an editable manner.

### <First Example>

Subsequently, an example of storing (saving) the apparatus information in five seconds before and after the occurrence of the failure as the failure data will be described. A first example of the embodiments of the present disclosure will be described by way of an example in which a gas flow rate deviation error of an "MFC3" (see FIG. 14) is reported from the gas flow rate controller 213 to the main controller 201 during the operation of the substrate processing apparatus 1.

It is assumed that such an abnormality described above is directly caused by a flow rate abnormality due to an operation of the valve on a primary supply side of the MFC3 due to a recipe setting error three seconds before the failure is reported.

In general, the cause cannot be identified because the apparatus information from three seconds before the failure is reported cannot be confirmed on the failure data display screen.

On the other hand, in the main controller 201 of the substrate processing apparatus 1 according to the present embodiments, a related screen (the gas information display region 310 in the present embodiments) is preferentially displayed in the failure data display screen 300 as shown in FIG. 14 and a relevant location (data of "MFC3" in the present embodiments) is displayed in a highlighted manner. Therefore, it is possible to easily grasp the location where the failure occurs.

In addition, a user can identify a direct cause of the failure (for example, a setting value error) by retroactively confirming a pre-set value of the valve on the primary supply side based on the apparatus information five seconds before and after the occurrence of the failure. In addition, since the execution recipe information can be confirmed and edited on the same screen, it is possible to solve such a problem described above by resetting the value corresponding to the relevant location to a correct value.

### <Second Example>

Subsequently, as a second example of the embodiments of the present disclosure, an example in which an R-axis unlock error is reported from the transfer controller 231 to the main controller 201 during the operation of the substrate processing apparatus 1 will be described.

It is assumed that such an abnormality described above is caused by a structure misalignment due to an insufficient supply of air to a lock structure. In the main controller 201 of the substrate processing apparatus 1 according to the present embodiments, a related screen (a sensor information display region (not shown) of the drive sensor in the present embodiments) is preferentially displayed in the failure data display screen 300 and a relevant location (the sensor information of the drive sensor of the lock structure of the R-axis in the present embodiments) is displayed in a highlighted manner. Therefore, it is possible to easily grasp the location where the failure occurs.

In addition, based on the apparatus information five seconds before and after the occurrence of the failure, it is possible to confirm a timing of turning off the sensor and a fluctuation which tends to occur as an abnormality in case of a lack of the air.

According to the present embodiments, it is possible to obtain one or more of the following effects.

In the substrate processing apparatus 1 according to the present embodiments, when the failure occurs, the first apparatus-related information reported before the failure during the first period defined in advance and the recipe are stored as the failure data together with the occurrence time of the failure in the memory 222. Further, the substrate processing apparatus 1 further performs the control operation of adding the second apparatus-related information reported after the failure during the second period defined in advance to the failure data. Thereby, it is possible to rapidly identify the cause of the occurrence of the failure and it is also possible to support the recovery.

Further, since the apparatus information corresponding to the failure information that has occurred is stored for a predetermined amount of time before and after the failure has occurred, it is possible to easily manage the data regarding the failure information that has occurred. In addition, by displaying the data for a predetermined period of time before and after the occurrence of the failure, it is possible to confirm the change in the apparatus information before and after the occurrence of the failure, and it is also possible to support in identifying the cause of the occurrence of the failure.

In addition, the failure data stored as described above can be stored (saved) in the external host computer 202 via the external communication interface 229 or in the recording medium via the external memory 221. When the failure data is stored in the external host computer 202 or the recording medium, it is possible to avoid a pressure on a capacity of the memory 222 in the main controller 201.

Further, conventionally, since the apparatus information related to the failure information is acquired from the memory 222 when the screen is displayed, it takes time to display the apparatus information. However, according to the present embodiments, since the apparatus information related to the failure information is collected when the failure occurs and after the failure occurs, it is possible to display the apparatus information within a scope of the data collected as described above while the screen is displayed, and it is also possible to avoid a waiting time when the screen is displayed.

Further, since the failure data collected as described above contains the apparatus information for a period defined in advance before and after the occurrence of the failure, it is possible to confirm the status of the apparatus before or after the occurrence of the failure. Thereby, it is possible to investigate the cause of the failure. As a result, it is possible to shorten a period until the cause of the failure is identified, and it is also possible to contribute reducing a downtime.

Further, after the cause of the failure is identified, it is possible to edit the recipe for a target item (that is, the item to be edited) from the failure data display screen. Thereby, it is also possible to avoid a correction error.

In addition, since it is possible to display the apparatus information related to the failure in the chronological order, it is possible to easily confirm the abnormality before the failures occur.

In addition, the user can refer to the apparatus information and the recipe information for several seconds before and after the failure is reported on the same screen. Thereby, it is possible to rapidly identify the cause of the failure. In addition, since the execution recipe can be edited directly from a failure screen, it is possible to shorten a time until the failure is solved, and it is also possible to reduce the downtime of the apparatus such as the substrate processing apparatus 1.

### <Other Embodiments of Present Disclosure>

While the technique of the present disclosure is described in detail by way of the embodiments described above, the technique of the present disclosure is not limited thereto. The technique of the present disclosure may be modified in various ways without departing from the scope thereof. For example, the substrate processing apparatus 1 according to the embodiments described above is described above as an example. However, the technique of the present disclosure may also be applied to a program that causes a computer to perform the functions of the substrate processing apparatus 1. Further, the technique of the present disclosure may also be applied to a non-transitory computer-readable recording medium storing the program that causes the computer to perform the functions of the substrate processing apparatus 1.

In addition, the configuration of the substrate processing apparatus 1 described in the embodiments is merely an example, and may be changed in accordance with circumstances without departing from the scope of the technique of the present disclosure.

In addition, the process flow of the program described in the embodiments is merely an example, and may be changed. For example, an unnecessary step may be deleted, a new step may be added, or a process sequence may be changed without departing from the scope of the technique of the present disclosure.

For example, the embodiments described above are described by way of an example in which the processing according to the embodiments is implemented by a software configuration that uses the computer to execute program. However, the technique of the present disclosure is not limited thereto. For example, the technique of the present disclosure may also be applied to a hardware configuration capable of performing the processing, or may also be applied to a combination of hardware and software configuration capable of performing the processing.

Further, the substrate processing apparatus 1 according to the embodiments of the present disclosure may include not only a semiconductor manufacturing apparatus but also an apparatus capable of processing a glass substrate such as an LCD (Liquid Crystal Display) device. In addition, the technique of the present disclosure can be applied to various substrate processing apparatuses such as an exposure apparatus, a photolithography apparatus, a coating apparatus and a processing apparatus using a plasma.

For example, the embodiments described above are described by way of an example in which the failure data and the apparatus information are stored in the memory 222 of the main controller 201. However, the technique of the present disclosure is not limited thereto. For example, the failure data and the apparatus information may be stored in a component such as a USB, a CD and a DVD connected to the external memory 221. For example, the failure data and the apparatus information may be transmitted to the external host computer 202 connected to the external communication interface 229 through the network.

For example, the embodiments described above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates at a time is used to form the film. For example, the embodiments described above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The process sequences and the process conditions of each process using the substrate processing apparatuses exemplified above may be substantially the same as those of the embodiments described above. Even in such a case, it is possible to obtain substantially the same effects as in the embodiments described above.

The invention may be summarized as follows: According to the present disclosure, there is provided a technique capable of rapidly identifying a cause of an occurrence of a failure and supporting a recovery. There is provided a technique that includes: a memory storing recipes, apparatus information reported from within the substrate processing apparatus and failure information; a process vessel in which a substrate is processed based on a recipe; and a controller for: (i) storing failure data in the memory together with an occurrence time of the failure contained in the failure information when the failure occurs in the substrate processing apparatus, the failure data containing first apparatus-related information reported before the failure during a first period defined in advance and the recipe in the memory; and (ii) adding second apparatus-related information reported after the failure during a second period defined in advance to the failure data.

### [Industrial Applicability]

The technique of the present disclosure relates to a function capable of supporting an analysis of the cause of the failure occurred in the apparatus, and can be applied to various substrate processing apparatuses.

### [Description of Reference Numerals]

- 1: Substrate processing apparatus
- 28: Process vessel
- 201: Main controller
- 220: Controller
- 222: Memory

## Claims

1. A substrate processing apparatus comprising:
a memory configured to store a plurality of recipes in which process conditions of a substrate are defined, apparatus information reported from within the substrate processing apparatus and failure information generated when a failure occurs in the substrate processing apparatus;
a process vessel in which a processing of the substrate is capable of being executed based on a recipe designated among the plurality of recipes; and
a controller configured to be capable of (i) storing failure data in the memory together with an occurrence time of the failure contained in the failure information when the failure occurs in the substrate processing apparatus, the failure data containing first apparatus-related information reported before the failure during a first period defined in advance and the recipe in the memory; and (ii) adding second apparatus-related information reported after the failure during a second period defined in advance to the failure data.

2. The substrate processing apparatus of claim 1, wherein the apparatus information contains at least one selected from the group of process system information or transfer system information reported while the substrate processing apparatus is in operation.

3. The substrate processing apparatus of claim 2, wherein the process system information contains information reported when there is a change in at least one among a temperature, a gas and a pressure.

4. The substrate processing apparatus of claim 2 and/or 3, wherein the transfer system information contains information reported when there is a change in an operation of a structure of the substrate processing apparatus.

5. The substrate processing apparatus of any one or more of claims 1 to 4, wherein the first period and the second period are capable of being set by parameters, and
wherein the controller is further configured to be capable of obtaining the first apparatus-related information and the second apparatus-related information by referring to the first period and the second period set by the parameters when the failure occurs.

6. The substrate processing apparatus of any one or more of claims 1 to 5, wherein the memory is configured to store the recipe designated among the plurality of recipes when the processing of the substrate is executed and a start time of an execution of the processing of the substrate.

7. The substrate processing apparatus of any one or more of claims 1 to 6, wherein the apparatus information stored in the memory is updated using the first apparatus-related information in a case where the first period has passed after being reported.

8. The substrate processing apparatus of any one or more of claims 1 to 7, wherein the controller is further configured to be capable of adding the second apparatus-related information to the failure data in a case where the second period has passed after the failure occurs.

9. The substrate processing apparatus of any one or more of claims 1 to 8, further comprising
an operation display structure configured to be capable of displaying the failure data,
wherein the controller is further configured to be capable of acquiring the failure data corresponding to the occurrence time of the failure, and capable of displaying the recipe, the first apparatus-related information, the second apparatus-related information and the failure information during the first period and the second period on a same screen of the operation display structure.

10. The substrate processing apparatus of claim 9, wherein the operation display structure is further configured to be capable of designating a date and time, and
wherein the controller is further configured to be capable of switching a display of the failure data in accordance with the date and time designated by using the operation display structure,

11. The substrate processing apparatus of claim 9 and/or 10, wherein the controller is further configured to be capable of identifying an occurrence location of the failure by referring to information contained in the failure information, and
wherein the operation display structure is configured to preferentially display the occurrence location of the failure.

12. The substrate processing apparatus of any one or more of claims 9 to 11, wherein the operation display structure is provided with a recipe editing function, and is further configured to be capable of editing an item of the recipe corresponding to a portion designated by using the operation display structure while the failure data is being displayed.

13. The substrate processing apparatus of any one or more of claims 9 to 12, wherein the controller is further configured to be capable of identifying an occurrence location of the failure by referring to information contained in the failure information, and
wherein the controller is further configured to be capable of acquiring the apparatus information during a third period related to the occurrence location of the failure and capable of displaying the apparatus information during the third period on the operation display structure in a chronological order.

14. A method of manufacturing a semiconductor device, comprising:
(a) processing a substrate based on a recipe in which process conditions of the substrate are defined;
(b) storing the recipe, apparatus information reported while the substrate is being processed and failure information reported when a failure occurs;
(c) storing failure data containing first apparatus-related information reported before the failure during a first period defined in advance and the recipe when the failure occurs together with an occurrence time of the failure contained in the failure information; and
(d) adding second apparatus-related information reported after the failure during a second period defined in advance to the failure data.

15. A program that causes a substrate processing apparatus, by a computer, to perform:
(a) processing a substrate based on a recipe in which process conditions of the substrate are defined;
(b) storing the recipe, apparatus information reported while the substrate is being processed and failure information reported when a failure occurs;
(c) storing failure data containing first apparatus-related information reported before the failure during a first period defined in advance and the recipe when the failure occurs together with an occurrence time of the failure contained in the failure information; and
(d) adding second apparatus-related information reported after the failure during a second period defined in advance to the failure data.
